# EUROPÄISCHE PATENTSCHRIFT

(11) **EP 2 982 226 B1**
(45) Veröffentlichungstag und Bekanntmachung des Hinweises auf die Patenterteilung: **17.08.2016**
(21) Anmeldenummer: 14718312.3
(22) Anmeldetag: 17.03.2014
(51) Int. Cl.: H05K 1/18

(54) **VERFAHREN ZUM HERSTELLEN EINES LEITERPLATTENELEMENTS**
METHOD FOR PRODUCING A CIRCUIT BOARD ELEMENT
PROCÉDÉ DE FABRICATION D'UN ÉLÉMENT DE CIRCUIT IMPRIMÉ

(30) Priorität: 02.04.2013 AT 502222013
(43) Veröffentlichungstag der Anmeldung: 10.02.2016
(73) Patentinhaber: AT & S Austria Technologie & Systemtechnik Aktiengesellschaft, 8700 Leoben-Hinterberg (AT)
(72) Erfinder: STAHR, Johannes, A-8605 St. Lorenzen (AT); ZLUC, Andreas, A-8700 Leoben (AT)
(74) Vertreter: Sonn & Partner Patentanwälte
(86) Internationale Anmeldenummer: PCT/AT2014/050066
(87) Internationale Veröffentlichungsnummer: WO 2014/161020

(56) Entgegenhaltungen:
- US-A1- 2003 104 654
- US-A1- 2005 285 244
- US-A1- 2010 029 047
- US-A1- 2011 127 076

## Beschreibung

Die Erfindung betrifft ein Verfahren zum Herstellen eines Leiterplattenelements mit wenigstens einem elektronischen Bauteil, der eine durch elektrische Kontakte oder eine leitende Schicht definierte Anschlussseite aufweist und zur Positionierung mit einem temporären Träger verbunden und in einem Isoliermaterial eingebettet wird, wobei der Bauteil direkt auf einer Kunststofffolie als temporärer Träger in einer vorgegebenen Position angebracht wird. Ein derartiges Verfahren ist aus US 2010/0029047 A1 bekannt, wobei das Isoliermaterial durch eine Leiterplatte gebildet ist.

Im Zusammenhang mit wachsenden Produktfunktionalitäten von mit elektronischen Bauteilen versehenen Geräten und einer zunehmenden Miniaturisierung derartiger elektronischer Bauteile sowie einer immer größeren Anzahl von elektronischen Bauteilen, mit welchen Leiterplatten zu bestücken sind, werden in der Technik zunehmend leistungsfähigere arrayförmig aufgebaute Einheiten bzw. Packages mit mehreren elektronischen Bauteilen eingesetzt, die eine Vielzahl von Kontakten bzw. Anschlüssen bei zunehmend verringertem Abstand dieser Kontakte aufweisen. Aus diesem Grund wird - bei einer gleichzeitigen Verringerung der Produktgröße der einzusetzenden Bauteile und der Leiterplatten - eine Bestückung der elektronischen Bauteile über die erforderliche Vielzahl von Kontaktstellen immer schwieriger.

Es wurde bereits vorgeschlagen, elektronische Bauteile wenigstens teilweise in eine Leiterplatte zu integrieren, vgl. beispielsweise WO 03/065778 A, WO 03/065779 A oder WO 2004/077902 A. Bei diesen bekannten Techniken ist jedoch nachteilig, dass für die Aufnahme der elektronischen Bauteile Vertiefungen oder Löcher, d.h. Kavitäten, in einem Grundelement, dem Substrat der Leiterplatte, vorzusehen sind. Für die Kontaktierung der Bauteile werden Lötprozesse und Bondtechniken eingesetzt, wobei üblicherweise Kontaktstellen zwischen Materialien unterschiedlichen Typs (einerseits Leiterbahnen und andererseits Kontakt- bzw. Anschlussstellen der elektronischen Bauteile) resultieren. Vor allem bei einem Einsatz derartiger Systeme in Umgebungen mit großen Temperaturunterschieden bzw. Temperaturwechselbereichen ergeben sich durch die unterschiedlichen Materialien im Bereich der Kontakt- bzw. Anschlussstellen wegen der unterschiedlichen thermischen Ausdehnungskoeffizienten Spannungen, welche zu Rissen von Kontakt- bzw. Anschlussstellen und somit zum Versagen der Einheit führen können. Darüber hinaus ist davon auszugehen, dass zusätzlich erforderliche Bohrungen, insbesondere Laserbohrungen, zur Herstellung von Kontakten die Komponenten belasten. Weiters ist nachteilig, dass eine Kontaktierung der in den herzustellenden Kavitäten eingesetzten Bauteile an Leiterbahnen und Kontaktflächen durch Lötpasten oder Bonddrähte erschwert wird bzw. insbesondere bei einem Einsatz mit schwankenden Temperaturbelastungen nicht zuverlässig erzielbar ist. Auch können hohe Drücke und Temperaturen während des Leiterplatten-Herstellungsprozesses die eingebetteten und kontaktierten Bauteile belasten. Weiters ist eine Wärmeableitung von gegebenenfalls stärker belasteten, elektronischen Bauteilen problematisch.

In der WO 2010/048654 A1 ist eine Technik zur Integration eines elektronischen Bauteils in eine Leiterplatte beschrieben, bei der auf einem später entfernten Träger, auf dem eine vorzugsweise elektrisch leitende Schicht angebracht wurde, der Bauteil mithilfe eines Klebers befestigt wird. Der Bauteil wird sodann in einem isolierenden Material eingebettet, auf dem wiederum eine leitende Schicht angebracht wird. Bei diesem Aufbau hat die Isolierschicht, beispielsweise ein Prepreg-Material, beim Erwärmen einen anderen Ausdehnungskoeffizienten als der Kleber, sodass es bei den nachfolgenden Aufheiz- und Aushärteschritten zu einem Verwerfen des Leiterplattenelements - insbesondere im Bereich des Bauteils - kommt. Diese Verwerfungen können beispielsweise in der Größenordnung von ca. 150 µm liegen. Überdies ergeben sich auch bei der Kontaktierung des Bauelements mithilfe von Mikro-Bohrlöchern, sogenannten µVias, Probleme.

Ähnliches gilt auch für die in der DE 10 2009 029 201 A1 beschriebene Technik zur Herstellung eines mikro- oder nanostrukturiertes Bauelement umfassenden Bauteils. Hier wird ein mehrlagiger Träger eingesetzt, der über eine Verbindungsschicht eine elektrisch leitende Schicht trägt, wie insbesondere eine sogenannte RCC-Folie (Resin-Copper-Coated), nämlich mit einer Epoxidschicht und einer Kupferschicht, wobei die Kupferschicht über eine Verbindungsschicht mit dem später entfernten eigentlichen temporären Träger verbunden ist. Die Epoxidschicht und die Kupferschicht verbleiben am Leiterplattenelement. Auf diesen Schichten wird, solange noch der eigentliche Träger vorhanden ist, die Gruppe von elektronischen Bauteilen oder Komponenten angebracht, wonach diese mit einem Isoliermaterial umhüllt werden. Auch hier ergibt sich bei den Heiz- und Aushärtungsvorgängen aufgrund der unterschiedlichen Ausdehnungskoeffizienten ein Verziehen oder Verwerfen des hergestellten Leiterplattenelements.

Es ist nun Ziel der Erfindung, diesen Problemen zumindest weitestgehend abzuhelfen und die Herstellung von Leiterplatten bzw. Leiterplattenelementen zu ermöglichen, bei der eine zuverlässige Integration von elektronischen Bauteilen, insbesondere auch bei vereinfachter Kontaktierung, ermöglicht wird. Insbesondere soll ein Aufbau während der Herstellung der Leiterplatten ermöglicht werden, der eine Symmetrie in Bezug auf die jeweils verwendeten Materialien ermöglicht, sodass bei den Heiz- und Press- bzw. Aushärtevorgängen ein Verwerfen der Leiterplatte vermieden werden kann. Weiters ist auch die Erzielung einer Blasenfreiheit des Leiterplattenaufbaus angestrebt.

Demgemäß sieht die Erfindung ein Verfahren zum Herstellen eines Leiterplattenelements wie eingangs angegeben vor, das sich dadurch auszeichnet, dass nach dem Anbringen des Bauteils auf der Kunststofffolie auf der der Kunststofffolie gegenüberliegenden Seite des Bauteils eine Verbundlage mit zumindest einem Träger und einem elektrischen Leiter, vorzugsweise auch mit einem Isoliermaterial, mit dem Träger vom Bauteil abgewandt, angebracht wird, dass danach die Kunststofffolie abgelöst wird, und dass dann der Bauteil in Isoliermaterial eingebettet wird.

Vorteilhafte Ausführungsformen und Weiterbildungen dieses Verfahrens sind in den abhängigen Ansprüchen angegeben.

Beim vorliegenden Verfahren kann nicht nur auf die Verwendung eines Substrats der Leiterplatte verzichtet werden, in dem Hohlräume (Kavitäten) für die Bauteile hergestellt werden müssen (vgl. US 2010/0029047 A1), sondern es wird auch eine erhöhte Zuverlässigkeit im Hinblick auf die mögliche Fehlerfreiheit der Leiterplatte, genauer des den elektronischen Bauteil umgebenden Materials, erzielt, da Lufteinschlüsse vermieden werden können, wie sie sonst vor allem bei der Integration größerer Bauteile immer wieder auftreten. Dies wird dadurch ermöglicht, dass die jeweiligen Aufheiz- bzw. Härtungs- oder Laminierschritte unter Vakuum erfolgen können, wodurch sich keine Luftblasen innerhalb der Materials halten können; die Vermeidung derartiger Lufteinschlüsse ist insbesondere in den Kontaktbereichen von Vorteil. Wesentlich für das vorliegende Verfahren ist auch, dass der gesamte temporäre Träger während des Verfahrens wieder entfernt wird, und eine symmetrische Struktur des Leiterplattenaufbaus ermöglicht wird, was wesentlich dazu beiträgt, dass ein Verwerfen der hergestellten Leiterplatten bei den Aushärtungsschritten, zufolge von verschiedenen Polymerisations-Schrumpfungen im Fall von verschiedenen Materialien, vermieden werden kann. Für diese symmetrische Struktur ist es demgemäß auch von besonderem Vorteil, wenn nach der Einbettung des Bauteils in Isoliermaterial eine weitere Verbundlage, die zumindest einen elektrischen Leiter und einen Träger, vorzugsweise auch ein Isoliermaterial, aufweist, auf der, der ersten Verbundlage gegenüberliegenden Seite auf dem Bauteil und auf dessen Einbettung aufgebracht wird. Weiters wird mit einer derartigen Vorgangsweise auch in vorteilhafter Weise ermöglicht, eine Multilayer-Leiterplatte aufzubauen, in der somit in .mehreren Ebenen Schaltungsteile realisiert sind.

Unter "Einbetten" soll hier sowohl ein bloß seitliches Ummanteln des oder der Bauteile als auch ein solches Ummanteln samt Abdecken verstanden werden.

Als temporärer Träger kann einfach eine - an sich herkömmliche - Klebefolie eingesetzt werden, wobei diese Klebefolie zweckmäßig aus einer Klebeschicht, beispielsweise mit Acryl oder Silikon, auf einer Trägerschicht, beispielsweise aus PET-Material, oder einer dünnen Metallfolie, beispielsweise Aluminium, aufgebaut sein kann. Derartige Klebefolien oder Klebestreifen sind im Handel erhältlich und werden auch als "sticky tape" bezeichnet.

Im Zuge der Einbettung des elektronischen Bauteils wird - ähnlich wie gemäß der DE 10 2009 029 201 A1 - eine Art "Substratkörper" für die Leiterplatte erhalten. Bei diesem Schritt des Einbettens des elektronischen Bauteils im Isoliermaterial kann der elektronische Bauteil auch auf seiner von der "Anschlussseite" abgewandten Seite abgedeckt werden, was jedoch nicht unbedingt der Fall sein muss. Unter "Anschlussseite" wird hier jene Seite des Bauteils verstanden, an der die elektrischen Kontakte des Bauteils vorliegen oder aber zumindest die größere Anzahl von Kontakten vorliegt, wobei dann auch auf der gegenüberliegenden Seite, der Rückseite, nichtsdestoweniger eine Leiterschicht oder Metallisierung vorliegen kann, wie nachstehend noch näher erläutert werden wird.

Für die Einbettung ist nun eine vorteilhafte Vorgangsweise dadurch gekennzeichnet, dass der Bauteil in einem als Isoliermaterial zur Einbettung eingesetzten vorkonditionierten Prepreg-Material, das eine Ausnehmung für den Bauteil aufweist, eingebettet wird. Hierbei wird auf eine gängige Technik in der Leiterplattenherstellung insofern zurückgegriffen, als vorkonditionierte Prepreg-Materialien ganz allgemein für den Aufbau von Substraten und Isolierlagen in Leiterplatten üblich sind. Im vorliegenden Fall sind jedoch Ausnehmungen für die elektronischen Bauteile, sog. "Cavities" bzw. Kavitäten, im Prepreg-Material vorzusehen.

Eine günstige alternative Vorgangsweise zeichnet sich dadurch aus, dass der Bauteil im Isoliermaterial der Verbundlage, das eine Schichtdicke zumindest gleich der Dicke des Bauteils hat, eingebettet wird. Hierbei ist von Vorteil, dass sich ein eigener Schritt, in dem das Isoliermaterial gesondert vorgesehen wird, erübrigt, da das Isoliermaterial der Verbundlage direkt zum Einbetten des elektronischen Bauteils verwendet wird.

Von Vorteil ist weiters beim vorliegenden Verfahren, dass eine dünne Isolierschicht an der Anschlussseite der elektronischen Bauteile erzielbar ist, wobei die vergleichsweise geringe Dicke dieser Isolierschicht zwischen den Kontakten der Bauteile und der beim fertigen Leiterplattenelement dort vorliegenden leitenden Oberfläche die elektrische Verbindung der Bauteile mit der strukturierten leitenden Oberfläche erleichtert, wodurch hohe Verbindungsdichten erreicht werden können.

Derartige dünne Isolierschichten im Bereich der Kontakte der Bauteile können auch in vorteilhafter Weise erzielt werden, wenn ein Bauteil mit einer auf einer Seite von ihm angebrachten dielektrischen Schicht eingesetzt wird, wobei dieser Bauteil mit der, der dielektrischen Schicht gegenüberliegenden Seite auf der Kunststofffolie angebracht wird. In diesem Fall werden die elektronischen Bauteile somit mit der Anschlussseite nach oben, weg vom temporären Träger, also "face-up", auf dem temporären Träger angebracht. Auf dieser Seite wird sodann die Verbundlage, insbesondere ohne Isoliermaterial, aufgebracht, wonach auf der gegenüberliegenden Seite des oder der Bauteile der temporäre Träger entfernt wird, um dann von dieser Seite die Einbettung des oder der Bauteile im Isoliermaterial sowie bevorzugt die Anbringung der weiteren Verbundlage zu ermöglichen.

Bei Anbringung einer dielektrischen Schicht auf einer Seite des elektronischen Bauteils besteht die Möglichkeit, diese dielektrische Schicht oder Isoliermaterialschicht auf der "Anschlussseite" oder auf der den Kontakten gegenüberliegenden Seite des Bauteils anzubringen und sodann an dieser Seite die Verbundlage, ohne Isoliermaterial, sondern nur mit Träger und Leiter, anzubringen; danach wird wie angeführt der temporäre Träger von der Anschlussseite der Bauteile gelöst, und es wird die Ummantelung bzw. Einbettung der Bauteile vorgenommen.

Eine vorteilhafte Ausführungsform des vorliegenden Verfahrens zeichnet sich weiters dadurch aus, dass ein Bauteil mit einer auf einer Seite von ihm angebrachten elektrisch leitenden Schicht eingesetzt wird, wobei dieser Bauteil mit der, der elektrisch leitenden Schicht gegenüberliegenden Seite auf der Kunststofffolie angebracht wird. Bei dieser Vorgangsweise werden die Bauteile somit "face-down" auf dem temporären Träger angebracht. Die elektrisch leitende Schicht auf der den Kontakten gegenüberliegenden Seite der Bauteile kann einerseits zur Kontaktierung der Bauteile, etwa als Masse-Elektrode, sowie weiters auch zur Wärmeableitung dienen. Auch hier wird im übrigen bevorzugt eine Verbundlage ohne Isoliermaterial, also nur mit Träger und Leiter, auf der die elektrisch leitenden Schichten tragenden Seite der Bauteile angebracht.

Eine besonders rationelle Vorgangsweise ergibt sich weiters dann, wenn an der Verbundlage, bestehend aus Träger und elektrischem Leiter, ein z.B. pastenförmiges, elektrisch leitendes Material, z.B. durch Drucken, auf dem elektrischen Leiter der Verbundlage an der Stelle des Bauteils angebracht wird, bevor die Verbundlage mit dem Bauteil verbunden und danach die Kunststofffolie abgelöst wird. Bei dieser Vorgangsweise wird bei Anbringen der Verbundlage, mit den lokalen elektrisch leitenden Materialteilen, auf der dem temporären Träger für die Bauteile gegenüberliegenden Seite in ein und demselben Schritt eine Metallisierung an der Rückseite der elektronischen Bauteile ermöglicht.

Weiters ist es auch von Vorteil, wenn an der der Anschlussseite des Bauteils gegenüberliegenden Seite ein z.B. pastenförmiges, elektrisch leitendes Material nach dem Ablösen der Kunststofffolie, z.B. durch Drucken, aufgebracht wird. Bei dieser Vorgangsweise ergibt sich eine einfachere Registrierung bei den verschiedenen Prozessschritten, da sich eine Registrierung zur Leiterschicht der Verbundlage erübrigen kann.

Wie erwähnt können bei der vorliegenden Vorgangsweise die verschiedenen Heiz- und Aushärt- bzw. Laminierschritte in Vakuum erfolgen, und insbesondere können die Verbundlagen in Vakuum angebracht werden, um so die gewünschte Blasenfreiheit zu erzielen.

Von besonderem Vorteil ist es sodann beim vorliegenden Verfahren, wenn auf der Kunststofffolie zugleich mit dem Bauteil zumindest ein Registrierelement für die Verwendung bei nachfolgenden Verfahrensschritten aufgebracht wird. Durch die gleichzeitige Anbringung (Bestückung) der Registrierelemente mit den elektronischen Bauelementen kann nicht nur ein Einsparen eines Registrierungsschritts an herkömmlichen Registriermarken erzielt werden, sondern es wird auch eine besonders hohe Genauigkeit für die nachfolgenden Prozessschritte ermöglicht.

Für einen Ausgleich von gegebenenfalls unterschiedliche Höhen aufweisenden einzubettenden elektronischen Bauteilen und/oder zum Ausgleich von Produktionstoleranzen derartiger elektronischer Bauteile wird gemäß einer weiters bevorzugten Ausführungsform vorgeschlagen, dass mit der Kunststofffolie ein komprimierbares Material verbunden wird. Durch Vorsehen eines wenigstens teilweise komprimierbaren Materials für den temporären Träger können Höhenunterschiede bei Vorsehen bzw. Bearbeitung einer Mehrzahl von elektronischen Bauteilen in einfacher und zuverlässiger Weise berücksichtigt werden, ohne aufwändige Adaptierungsarbeiten beispielsweise an der Herstellungsanlage oder den Einsatz unterschiedlicher Ausgangsmaterialien zu erfordern.

Aus Gründen der Formstabilität hat es sich auch als vorteilhaft gezeigt, wenn der Träger der Verbundlage und/oder der weiteren Verbundlage aus einem dimensionsstabilen Material, wie einem Metall, z.B. aus Kupfer, Aluminium, oder einem dimensionsstabilen Polymer, welches insbesondere eine UV-Durchlässigkeit aufweist, gebildet wird.

Von besonderem Vorteil für den Laminiervorgang, im Hinblick auf eine besonders einfache und zuverlässige Verbindung zwischen der Verbundlage und dem Bauteil und/oder der den Bauteil umgebenden Schicht ist es, wenn das Isoliermaterial der Verbundlage und/oder der weiteren Verbundlage aus einem Material, z.B. einem Duroplast, gebildet wird, das seine Viskosität während des Verbindens mit dem Bauteil ändert. In diesem Zusammenhang wird insbesondere vorgeschlagen, dass das seine Viskosität ändernde Material von einem Duroplast gebildet wird, welches nach dem Verbindungs-, insbesondere Laminierprozess, gehärtet wird.

Um bei der Herstellung einer Leiterplatte eine entsprechende mechanische Festigkeit und/oder Formstabilität während weiterer Be- bzw. Verarbeitungsschritte und/oder eines weiteren Einsatzes unter gegebenenfalls rauen Umgebungsbedingungen zu erzielen, wird darüber hinaus vorgesehen, dass das Isoliermaterial der Verbundlage und/oder der weiteren Verbundlage aus einem nicht-deformierbaren dielektrischen Material gebildet wird, auf dem eine weitere Schicht aus nichtleitendem Material angebracht wird, das seine Viskosität während des Verbindens mit dem Bauteil ändert. Ein derartiges dimensionsstabiles Material verleiht der herzustellenden Leiterplatte bzw. dem Leiterplatten-Zwischenprodukt eine ausreichende Formstabilität sowie Festigkeit.

Unter Berücksichtigung der im Rahmen der Herstellung einer Leiterplatte auftretenden erhöhten Temperaturen wird mit Vorteil weiters vorgesehen, dass als nicht-deformierbares dielektrisches Material ein Material mit einem Schmelzpunkt, der höher als 220 °C ist, insbesondere höher als 250 °C ist, gewählt wird. Derartige Anforderungen können in einfacher und zuverlässiger Weise beispielsweise dadurch erzielt werden, dass für das Isoliermaterial ein gehärtetes Duroplast, beispielsweise Epoxid, gewählt wird, wie dies einer weiters bevorzugten Ausführungsform des erfindungsgemäßen Verfahrens entspricht.

Im Sinn einer Minimierung der Dicke der Leiterplatte wird weiters vorgeschlagen, die leitende Schicht der Verbundlage(n) aus einem Metall, vorzugsweise Kupfer, mit einer Dicke von weniger als 20 µm, insbesondere einer Dicke zwischen 10 nm und 10 µm zu bilden; zur Herstellung derart dünner Metalllagen, insbesondere im Bereich von 10 nm oder einigen 10 nm, wird bevorzugt Sputtern angewendet.

Im Sinne einer dimensionsstabilen Ausbildung des temporären Trägers, für die Handhabung in den ersten Verfahrensschritten, wird weiters mit Vorteil auch vorgesehen, dass mit der Kunststofffolie eine dimensionsstabile Schicht, vorzugsweise ein Metallblech, verbunden wird, welche im Fall eines komprimierbaren Materials an dessen von dem Bauteil abgewandten Seite lösbar angebracht wird.

Nach der Einbettung des elektronischen Bauteils und der Verbindung zumindest mit der Verbundlage im Bereich der Kontakte oder der leitenden Oberfläche des elektronischen Bauteils wird für die Kontaktierung des eingebetteten Bauteils bevorzugt vorgesehen, dass nach dem Verbinden, insbesondere Laminieren des elektronischen Bauteils mit der Verbundlage sowie gegebenenfalls wenigstens einer weiteren Verbundlage an der anderen Seite eine Strukturierung zumindest der wenigstens einen leitenden Schicht des Verbunds und/oder eine Kontaktierung mit den Kontakten oder der leitenden Schicht des eingebetteten elektronischen Bauteils durchgeführt wird bzw. werden. Eine derartige Kontaktierung wird mit an sich bekannten Verfahrensschritten durchgeführt, wobei anstelle einer nachträglichen Strukturierung z.B. auch Ausbildungen von Verbundlagen eingesetzt werden können, in welchen beispielsweise die leitende Schicht entsprechend dem damit zu kontaktierenden elektronischen Bauteil bereits vorab strukturiert ist.

Wie bereits erwähnt, kann vorgesehen sein, dass eine Mehrzahl von gegebenenfalls unterschiedlichen Abmessungen, insbesondere unterschiedliche Höhen, aufweisenden elektronischen Bauteilen vorgesehen wird.

Die Erfindung wird nachfolgend anhand von in der beiliegenden Zeichnung schematisch dargestellten Ausführungsbeispielen noch weiter erläutert. In dieser zeigen:
Fig. 1a bis 1g aufeinanderfolgende Verfahrensschritte eines erfindungsgemäßen Verfahrens zur Integration wenigstens eines elektronischen Bauteils in einer Leiterplatte oder einem Leiterplatten-Zwischenprodukt;
Fig. 2a bis 2d aufeinanderfolgende Verfahrensschritte bei der Herstellung eines Leiterplattenelements gemäß einer anderen Ausführungsform des vorliegenden Verfahrens;
Fig. 3a bis 3c die Schritte eines weiteren, modifizierten Herstellungsverfahrens;
Fig. 4a bis 4g die Schritte eines Verfahrens zur Herstellung einer Leiterplatte oder eines Leiterplattenelements gemäß wieder einer anderen Ausführungsform des vorliegenden Verfahrens;
Fig. 5a bis 5g Verfahrensschritte gemäß noch einem anderen Herstellungsverfahren;
Fig. 6a bis 6g aufeinanderfolgende Verfahrensschritte gemäß wieder einem modifizierten Herstellungsverfahren gemäß der Erfindung;
Fig. 7 einen schematischen Teil-Querschnitt durch einen gegenüber den Ausführungsformen gemäß Fig. 1 bis 6 modifizierten temporären Träger 2, wobei weiters ganz schematisch und übertrieben zwei verschieden dicke Bauteile auf diesem temporären Träger gezeigt sind; und
Fig. 8 schematisch in einem Teil-Querschnitt ein Ausführungsbeispiel mit einer Verbundlage, die als Isoliermaterial Teilschichten, eine dimensionsstabile und eine aushärtbare Schicht, aufweist.

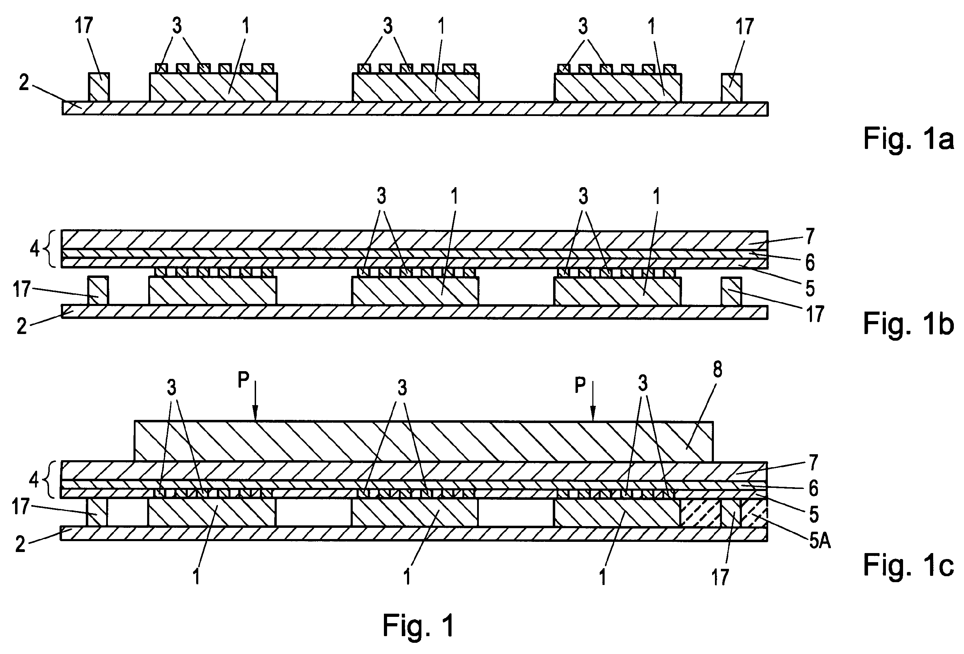

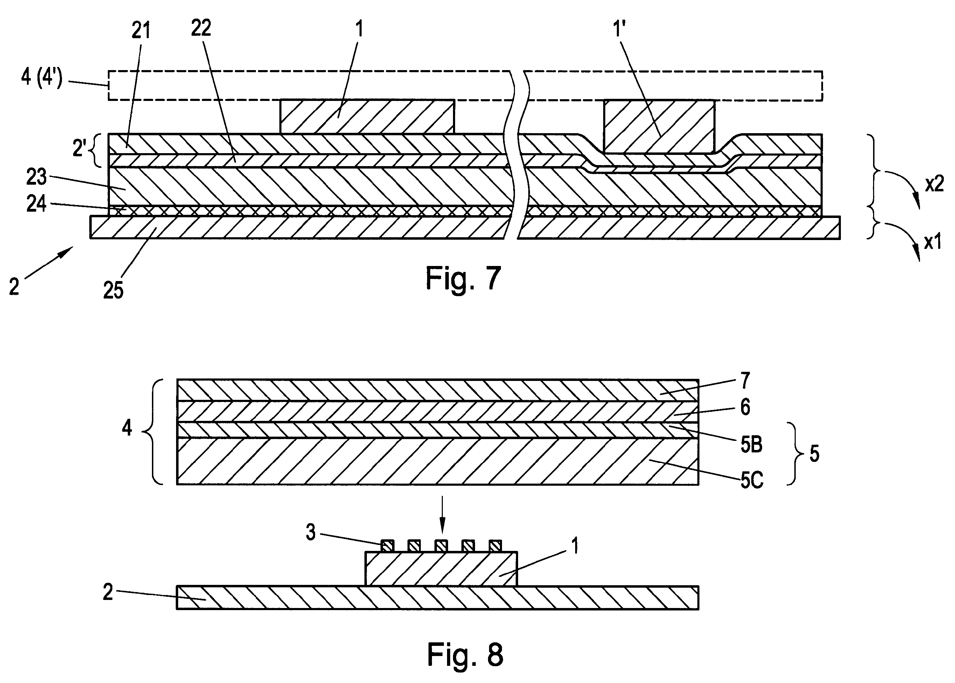

In Fig. 1a ist ersichtlich, dass eine Mehrzahl von elektronischen Bauteilen 1 auf einem temporären Träger 2 in Form einer Kunststofffolie 2, insbesondere Klebefolie 2'(s. Fig. 7), zur temporären Abstützung der Bauteile 1 angeordnet wird, wobei Kontakte 3 der elektronischen Bauteile 1 von der Kunststofffolie 2 abgewandt sind (sog. "face up"-Position). Anstelle der dargestellten Kontakte 3 kann auch an der von der Kunststofffolie 2 abgewandten Seite eine leitende, insbesondere strukturierte Oberfläche der einzubettenden bzw. zu integrierenden elektronischen Bauteile 1 vorgesehen sein. Diese Seite der Bauteile 1 wird nachfolgend der Einfachheit halber als Anschlussseite bezeichnet, wobei aber grundsätzlich auch die gegenüberliegende Seite eine oder mehrere Kontakte bzw. Leiterflächen, etwa als Masseanschluss, aufweisen kann. Beispielsweise haben IGBT-Bauteile an einer Seite einen Source- und einen Gate-Anschluss an der gegenüberliegenden Seite einen Drain-Anschluss.

Nachfolgend wird gemäß dem in Fig. 1b dargestellten Verfahrensschritt auf den elektronischen Bauteilen 1 an der Seite der Kontakte 3 eine Verbundlage 4 angeordnet, wobei bei der in Fig. 1b dargestellten Ausführungsform die Verbundlage 4 aus einer Schicht 5 aus einem nicht-leitenden Material (nachstehend kurz Isoliermaterial 5 oder Dielektrikumsschicht 5 bezeichnet), einer Schicht 6 aus einem leitenden Material (nachstehend kurz Leiter 6 bezeichnet) und einer Trägerschicht 7 (nachstehend kurz Träger 7 bezeichnet) besteht.

Die Verbundlage 4 kann den oder die einzubettenden bzw. zu integrierenden Bauteil(e) 1 gleichzeitig mit ihrem Isoliermaterial 5 überdecken.

Nachfolgend erfolgt gemäß dem in Fig. 1c dargestellten Verfahrensschritt eine Verbindung zwischen der Verbundlage 4 und den elektronischen Bauteilen 1. Diese Verbindung kann beispielsweise durch Laminieren vorgenommen werden, wobei hierzu, wie schematisch gezeigt, eine beheizte Druckvorrichtung bzw. ein Druckstempel 8 verwendet werden kann, vgl. auch die, die Druckausübung veranschaulichenden Pfeile P in Fig. 1c.

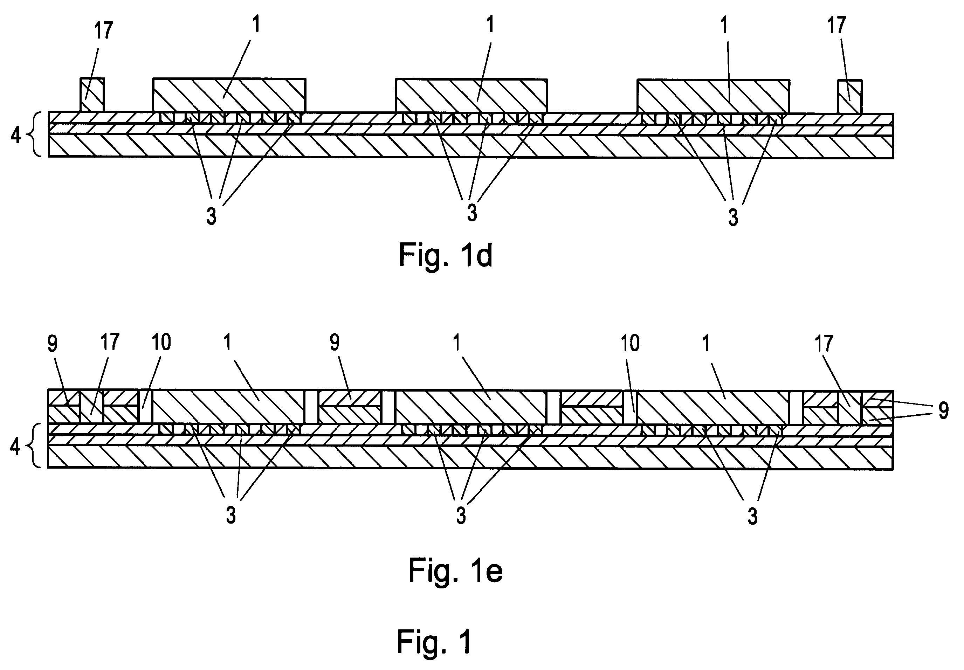

Nach der Verbindung der elektronischen Bauteile 1 mit dem Verbund 4, insbesondere unter Einbetten der Kontakte 3 im Isoliermaterial 5, wird die Kunststofffolie 2 entfernt und die erhaltene Einheit um 180° gewendet, wie dies in Fig. 1d angedeutet ist, um die Herstellung einer Leiterplatte bzw. eines Leiterplattenelements oder -Zwischenprodukts weiter fortzuführen.

Demgemäß ist in dem in Fig. 1e dargestellten Verfahrensschritt ersichtlich, dass zur Einbettung der elektronischen Bauteile 1 eine Ummantelung derselben durch eine Isolierschicht 9, z.B. durch Vorsehen weiterer Schichten bzw. Lagen 9 vorgenommen wird, die beispielsweise von einem Prepreg gebildet sind, welches mit entsprechenden Ausnehmungen oder Vertiefungen (Kavitäten) 10 in Übereinstimmung mit der Anordnung sowie den Abmessungen der elektrischen Bauteile 1 versehen ist.

Denkbar wäre hier aber auch ein Eingießen der Bauteile 1 in einem noch flüssigen Harz, das anschließend ausgehärtet wird.

Weiters könnte die Ummantelung der Bauteile 1 auch bereits im Schritt gemäß Fig. 1c erfolgen, wenn die Isolier- bzw. Dielektrikumsschicht 5 der Verbundlage 4 eine ausreichende Dicke hat, nämlich eine Dicke zumindest gleich der Dicke der Bauteile 1, wie dies in Fig. 1c schematisch bei 5A dargestellt ist; in diesem Fall wird somit jeder Bauteil 1 direkt im Isoliermaterial oder Dielektrikum 5 (bzw. 5A) der Verbundlage 4 eingebettet, d.h. ein gesondertes Isoliermaterial, wie etwa das Prepreg-Material 9 gemäß Fig. 1e, ist dann nicht erforderlich.

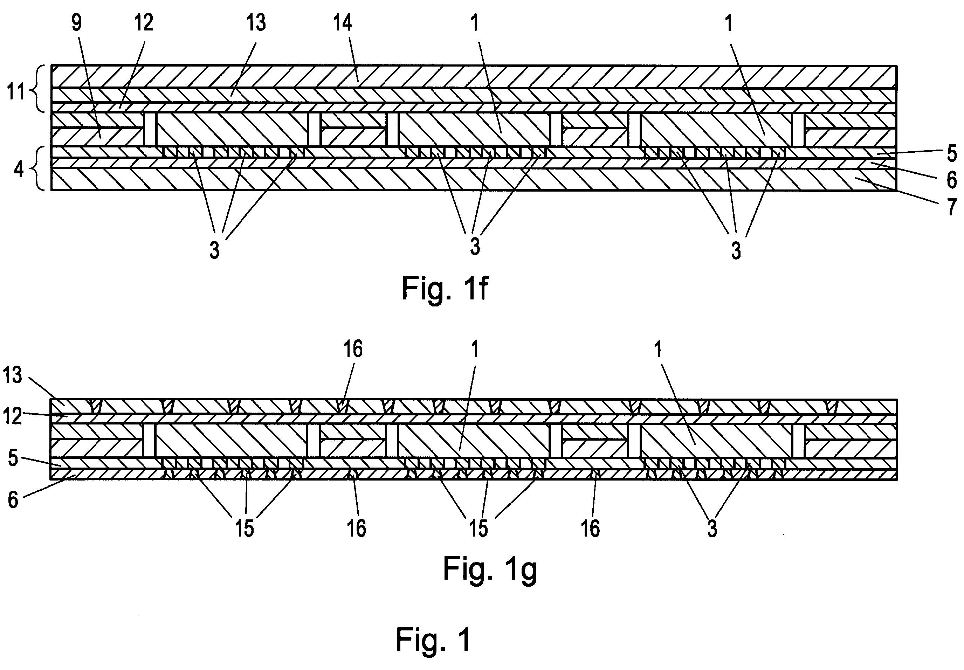

Für den weiteren Aufbau der herzustellenden Leiterplatte ist in Fig. 1f ersichtlich, dass zur Herstellung einer im Wesentlichen symmetrischen Anordnung nach Anbringung des Isoliermaterials 9 bzw. Prepregs 9 an der von den Kontakten 3 abgewandten Seite der Bauteile 1 ähnlich der Verbundlage 4 eine weitere Verbundlage 11 angeordnet werden kann. In weitestgehender Übereinstimmung mit dem Aufbau der Verbundlage 4 umfasst auch diese weitere Verbundlage 11 eine Schicht 12 aus einem nicht-leitenden Material, also eine Isolierschicht 12, eine Schicht 13 aus einem leitenden Material, also einem Leiter 13, sowie eine Trägerschicht 14 bzw. kurz einen (ablösbaren) Träger 14.

Diese weitere Verbundlage 11 ist bevorzugt möglichst gleich ("spiegelgleich") wie die Verbundlage 4 ausgebildet, um so eine Symmetrie in der in Fig. 1f gezeigten Struktur zu erzielen. Ein derartiger symmetrischer Aufbau ist von großem Vorteil beim nachfolgenden Fertiglaminieren und Aushärten, wie in Fig. 1g gezeigt, um so ein etwaiges Verbiegen oder "Schüsseln" bzw. Verziehen des Leiterplattenelements beim Laminiervorgang zum Aushärten aller Schichten, zur Folge eines unterschiedlichen Polymerisations-Schrumpfens, zu vermeiden. In diesem Zusammenhang ist es auch von Vorteil, dass bei der vorliegenden Vorgangsweise der temporäre Träger 2 komplett entfernt wird, sodass letztlich beidseits der Bauteile 1 eine symmetrische Struktur mit beispielsweise dem Isoliermaterial 5 bzw. 12 und den Leitern 6 bzw. 13 erhalten wird.

In Fig. 1f sind die einzelnen Schichten bzw. Lagen in einem miteinander verbundenen, insbesondere laminierten Zustand dargestellt, so dass insgesamt eine entsprechende Einbettung der Bauteile 1 bereits vorgenommen wurde.

Für eine weitere Be- bzw. Verarbeitung der herzustellenden Leiterplatte ist in Fig. 1g angedeutet, dass nach dem Entfernen der jeweiligen Träger 7 bzw. 14 die leitenden Schichten 6 und 13 der Verbundlagen strukturiert werden, wobei weiters Kontaktierungen 15 mit den Kontakten 3 der Bauteile 1 sowie zusätzliche Durchbrechungen 16 in den leitenden Schichten 6 bzw. 13 angedeutet sind. Derartige Strukturierungen bzw. Kontaktierungen sind für sich gesehen bekannt, so dass hierauf nicht näher eingegangen werden braucht.

Derartige weitere Vorgangsweisen sind selbstverständlich auch bei den nachfolgend erläuterten Verfahrensbeispielen hinzuzudenken.

Mit dem vorstehend (und dem nachstehend) beschriebenen Verfahren ist eine Einbettung von elektronischen Bauteilen 1 in "Leiterplatten" unabhängig von der Größe der Bauteile 1 möglich, und von besonderem Vorteil ist weiters, dass kein Kleber in die Leiterplatte eingebracht wird, der einen Fremdstoff bildet und zu Luftblasen führen kann. Die Fixierung der Bauteile 1 mit der Verbundlage 4 bzw. 11 kann in Vakuum erfolgen, wobei kein Lösungsmittel benötigt wird und Luftblasen vermieden werden. Weiters wird ein geringer Abstand zwischen den Kontakten 3 der Bauteile 1 und der mit ihnen (nach der Strukturierung) zu verbindenden Leiterschicht 6 erhalten, was bei der Anbringung von Laserbohrungen für die Kontaktierung von Vorteil ist. Überdies erfolgt die Verbindung der Bauteile 1 mit der Verbundlage 4 (und auch 11) in einem einzigen Schritt. Insgesamt können vergleichsweise besonders dünne Leiterplattenstrukturen auf die beschriebene Vorgangsweise erhalten werden.

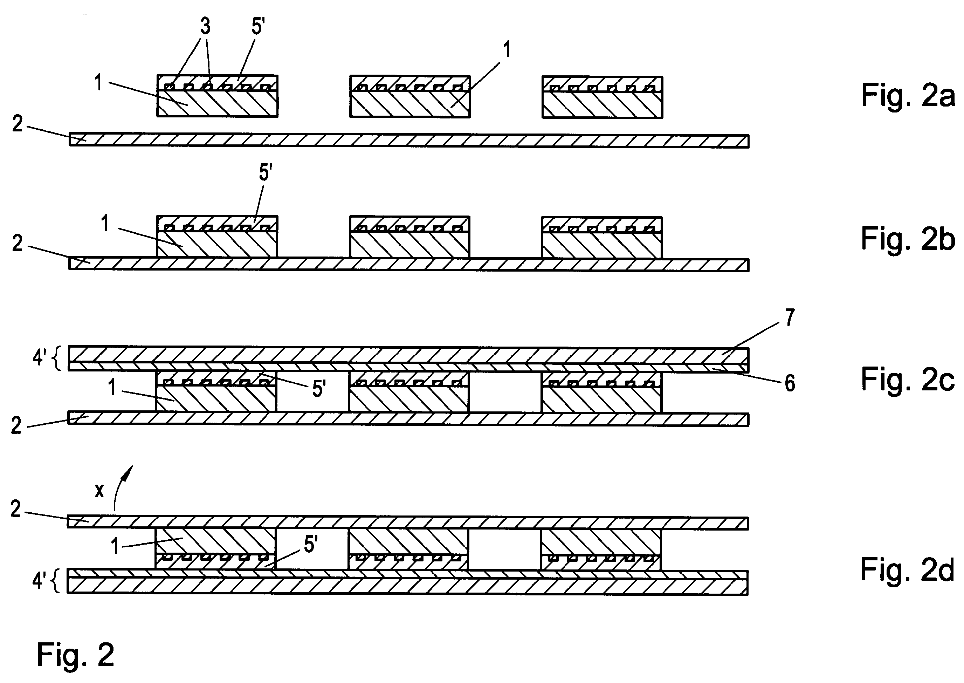

Diese Maßnahmen und Vorteile gelten auch für die nachfolgend beschriebenen Ausführungsbeispiele gemäß den Fig. 2 bis 8.

In den Teilfiguren Fig. 2a bis 2d der Fig. 2, wie auch in den nachfolgenden Figuren, werden Elemente, die Elementen der Fig. 1 entsprechen, mit entsprechenden Bezugszeichen, gegebenenfalls versehen mit Apostroph, wenn eine Modifikation vorliegt, bezeichnet.

Bei dem in Fig. 2 veranschaulichten Verfahren geht es wiederum darum, elektronische Bauteile 1 in einer festen Position relativ zu einer Leiterschicht 6 zu fixieren, wobei ebenfalls Lufteinschlüsse dort, wo ein dielektrisches Material angebracht wird, zu vermeiden sind.

Auch beim Verfahren gemäß Fig. 2 werden elektronische Bauteile 1 "face up", also mit der Anschlussseite nach oben, wie gemäß Fig. 1, auf einer darunter befindlichen, als temporärer Träger 2 fungierenden Kunststofffolie 2, insbesondere Klebefolie, aufgebracht, s. die Fig. 2a, in der die Bauteile 1 noch in Abstand oberhalb dieser Klebefolie 2 gezeigt sind, sowie die darauffolgende Verfahrensstufe gemäß Fig. 2b. Anders als bei dem Verfahren gemäß Fig. 1 wird sodann in der Folge keine Dreischichten-Verbundlage 4, sondern eine Zweischichten-Verbundlage 4' auf der Anschlussseite der Bauteile 1 angebracht. Dies ist deshalb so vorgesehen, weil zuvor, s. Fig. 2a, auf den Bauteilen 1 eine Isolierschicht bzw. dielektrische Schicht 5' über den Kontakten 3 angebracht wurde, wobei es sich hierbei beispielsweise um ein blasenfreies B-Stufen-Dielektrikum (also ein teilweise ausgehärtetes duroplastisches Isoliermaterial) handelt.

Gemäß Fig. 2c erfolgt - nach der Fixierung der Bauteile 1 auf der Klebefolie 2 gemäß Fig. 2b - die Anbringung der vorerwähnten zweischichtigen Verbundlage 4', mit einer Leiterschicht 6 und einer Trägerschicht 7.

Die lokalen dielektrischen Schichten 5' auf den Bauteilen 1 können besonders dünn sein, sodass ein besonders geringer Abstand zwischen den Bauteilen 1 und der Leiterschicht 6 der Verbundlage 4' erzielt werden kann, was beim späteren Kontaktieren der Anschlüsse 3, beim Bohren von Laserbohrungen oder Vias, wie erwähnt von besonderem Vorteil ist.

Das Auflaminieren der Verbundlage 4' auf die Bauteile 1, genauer auf deren dünne dielektrische Schichten 5', kann an sich auch mit nach unten weisender Anschlussseite der Bauteile 1, also "face down", erfolgen, d.h. bei Anbringen der Bauteile 1 mit den dielektrischen Schichten 5' auf der Kunststofffolie 2.

Im Weiteren kann beim Verfahren gemäß Fig. 2, so wie vorstehend anhand der Fig. 1d bis 1g vorgegangen werden, d.h. nach Wenden der Anordnung, s. Fig. 2d, und Ablösen des temporären Trägers 2, s. Pfeil x in Fig. 2d, werden die Bauteile 1 in einer Isolierschicht, z.B. Prepregs 9, eingebettet, es kann eine weitere Verbundlage 11 - eventuell auch ebenfalls ohne Isoliermaterial 5 - angebracht werden, wobei dann die Träger 7 bzw. 14 abgelöst werden. Das Laminieren bzw. Aushärten erfolgt bevorzugt wiederum unter Vakuum, wobei eines erhöhte Temperatur angewandt wird, um das Dielektrikum 5' endgültig auszuhärten. Auf diese Weise wird eine blasenfreie Verbindung zwischen den Bauteilen 1, den dielektrischen Schichten 5' und der Leiterschicht 6 bzw. 13 erzielt. Danach werden wiederum die Leiterlagen 6 bzw. 13 strukturiert und die Kontakte zu den Anschlüssen der Bauteile 1 hergestellt.

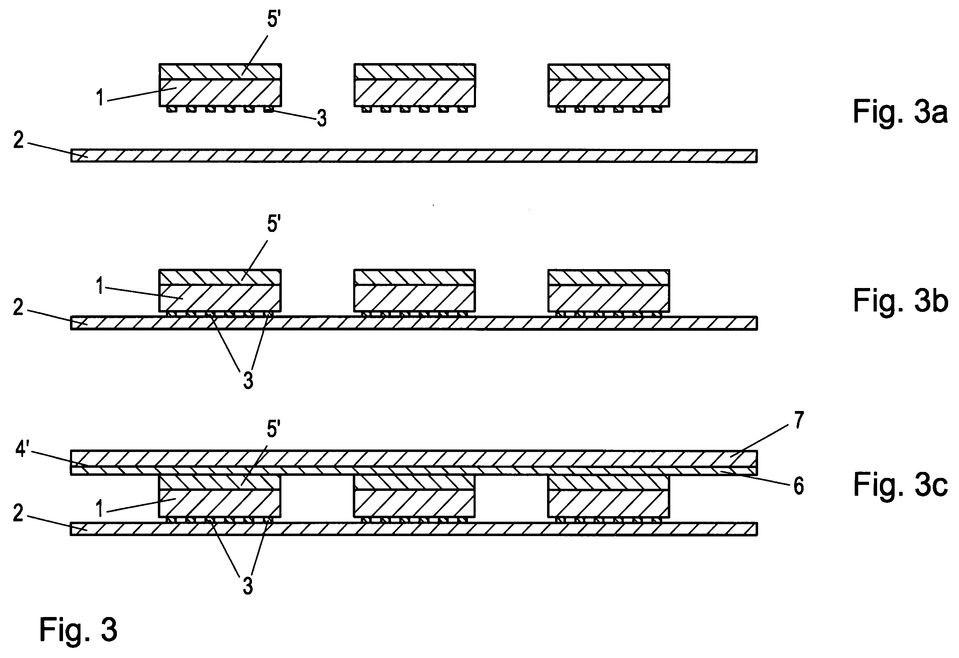

Bei dem in Fig. 3 veranschaulichten Verfahren werden ebenfalls mit einem Dielektrikum 5' beschichtete elektronische Bauteile 1 eingesetzt, jedoch befindet sich nunmehr, im Gegensatz zu Fig. 2, dieses Dielektrikum 5' jeweils auf der, der Anschlussseite, d.h. der mit den Kontakten 3 versehenen Seite, der Bauteile 1 gegenüberliegenden Seite. Die Bauteile 1 werden dann "face down", d.h. mit ihren Kontakten 3 der Kunststofffolie bzw. Klebefolie 2, die wiederum als temporärer Träger 2 eingesetzt wird, zugewandt auf dieser befestigt, s. Fig. 3a und 3b. Danach wird, gemäß dem Schritt, wie in Fig. 3c dargestellt, eine zweischichtige Verbundlage 4', nämlich ohne die Isolierschicht 5 gemäß Fig. 1, auf den Seiten der Bauteile 1, die von der Klebefolie 2 abgewandt sind, aufgebracht und auflaminiert. Sodann kann - was aber in Fig. 3 nicht weiter dargestellt ist - wiederum die erhaltene Struktur um 180° gewendet werden; die Klebefolie 2 wird abgezogen, und es kann dann eine zusätzliche Verbundlage 11 - hier mit Isolierschicht 12 - aufgebracht werden, nachdem die Bauteile 1 in Isoliermaterial, wie Prepregs 9 gemäß Fig. 1, eingebettet wurden.

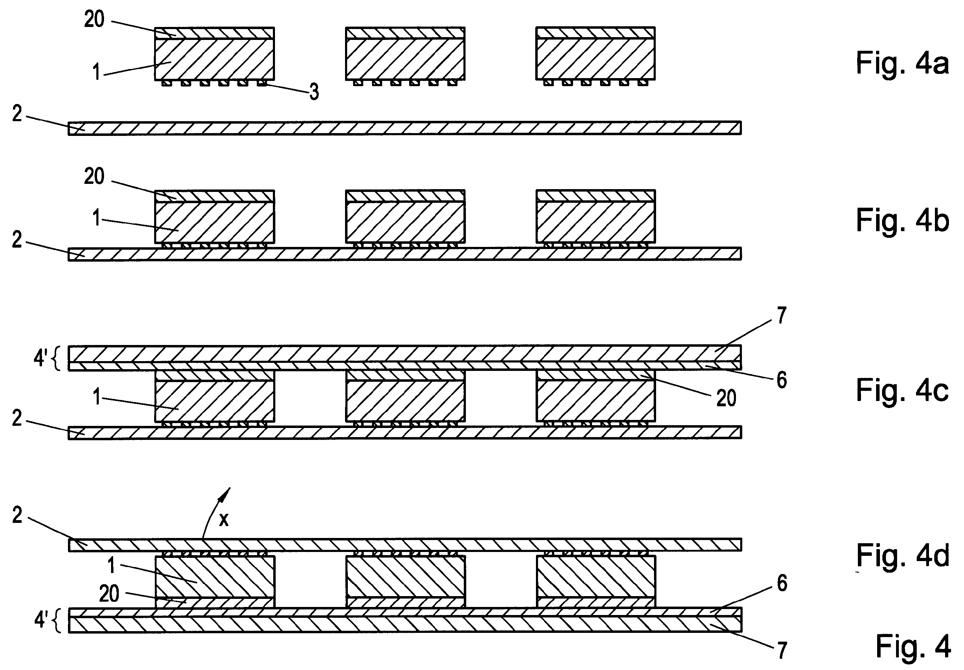

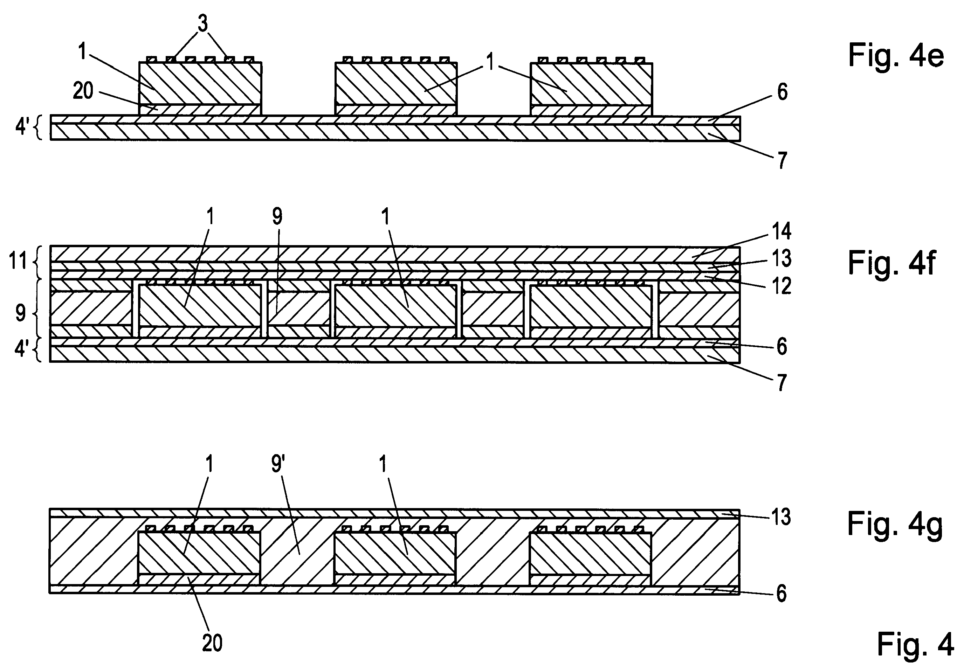

In den Teilfiguren 4a bis 4g der Fig. 4 ist eine weitere Variante des vorliegenden Verfahrens zur Herstellung von Leiterplatten bzw. Leiterplattenelementen veranschaulicht, wobei Bauelemente 1 eingesetzt werden, die auf ihrer den Kontakten 3 gegenüberliegenden Seite mit einem elektrisch leitenden Material 20 beschichtet sind, das ebenfalls blasenfrei aufgebracht werden kann und eine teilweise ausgehärtete ("B-stage"-) Schicht oder eine vorgetrocknete Schicht (Metallgranulat) bildet. Diese Bauelemente 1 werden hier wiederum "face down" auf eine als temporärer Träger 2 vorgesehene Klebefolie 2, allgemein Kunststofffolie 2, aufgebracht, s. Fig. 4b in Vergleich zu Fig. 4a. Danach'wird, ähnlich wie im Ausführungsbeispiel gemäß Fig. 3, eine Zweischichten-Verbundlage 4' mit einem Leiter 6 und einem Träger 7 auf der gegenüberliegenden Seite der Bauteile 1, auf den elektrisch leitenden Materialschichten 20 der Bauteile 1, aufgebracht, s. Fig. 4c. Diese Anordnung wird sodann um 180° gewendet, s. Fig. 4d, und die als temporärer Träger 2 fungierende Klebefolie 2 wird von den Bauteilen 1 bzw. deren Kontakten 3 abgelöst, s. Pfeil x in Fig. 4d. Danach wird ähnlich wie in Fig. 1f und 1g bereits veranschaulicht und anhand dieser Figuren beschrieben wiederum eine Ummantelung bzw. Einbettung der Bauteile 1 in Isoliermaterial, z.B. in Prepregs 9 mit darin vorgesehenen Ausnehmungen bzw. Kavitäten, vorgenommen, und es wird eine zusätzliche Verbundlage 11, mit Isoliermaterial 12, einem Leiter 13 und einem Träger 14, darauf angebracht, s. Fig. 4f. Anschließend werden die Träger 7 bzw. 14 abgelöst, und das Isoliermaterial 9 wird fertig ausgehärtet, sodass der Zustand gemäß Fig. 4g, mit einem ausgehärteten Isoliermaterial-Körper 9', erhalten wird. Danach erfolgen noch die beschriebenen, hier nicht mehr näher veranschaulichten Leiter-Strukturierungen und Kontaktierungen.

Auch beim Verfahren gemäß Fig. 4 kann die Laminierung unter Vakuum, bei erhöhter Temperatur, erfolgen, wobei eine blasenfreie Verbindung zwischen den Bauteilen 1, den elektrischen Leitermaterialien 6 bzw. 12 und den Leiterschichten 20 erzielt wird.

Das elektrisch leitende Material 20 auf den Bauteilen 1 kann aus einem Bandmaterial gewonnen werden, das ein Bindemittel in Form eines Harzes, das teilweise ausgehärtet ist (sich also in einer B-Stufe befindet) und Metallpulver, z.B. Silber, enthält. Dieses Material ist blasenfrei und wird auf der "Rückseite" der Bauteile 1 angebracht. Das Material dieser Schichten 20 ist bei Raumtemperatur nicht-klebend, und es ist eine erhöhte Temperatur erforderlich, wenn es mit der Metalllage, d.h. den Leitern 6, verbunden wird. Das leitende Material 20 kann bei der fertigen Leiterplatte zur Wärmeableitung und/oder als Kontakt, z.B. für die Drain-Elektrode eine IGBT-Transistors, dienen.

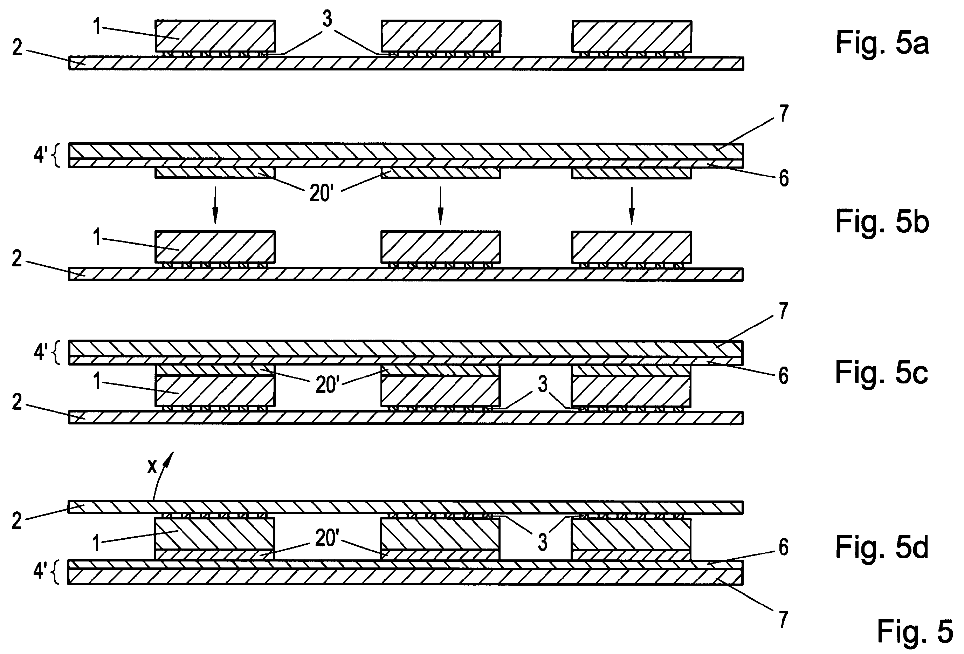

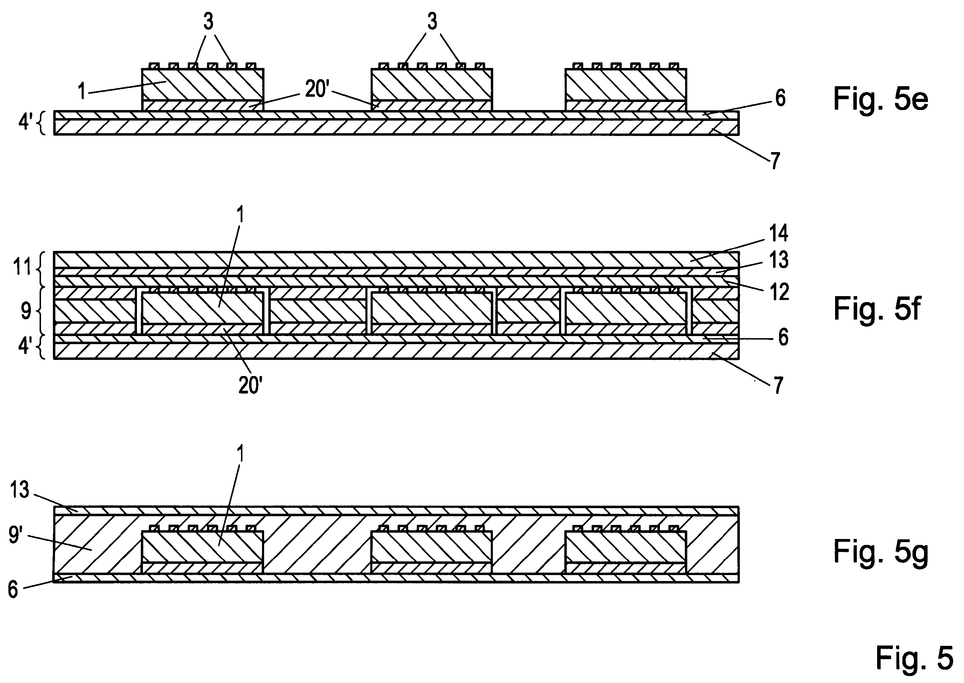

Die Verfahrensvariante gemäß Fig. 5 ist insofern gegenüber jener gemäß Fig. 4 modifiziert, als nunmehr, nach Aufbringen der Bauteile 1 mit der Seite, wo ihre Kontakte 3 vorhanden sind (also "face down"), auf der temporären Träger-Klebefolie 2 (Fig. 5a), die Bauteile 1 mit einer Verbundlage 4', enthaltend einen Träger 7 und einen Leiter 6, verbunden werden, wobei diese Verbundlage 4' überdies in Positionen entsprechend den Positionen der elektronischen Bauteile 1 (auf der Klebefolie 2) mit elektrisch leitendem Material 20' bzw. aus diesem Material entsprechenden Teilschichten 20' versehen ist. Diese Schichten 20' aus elektrisch leitendem Material entsprechen in ihrem Aufbau bzw. ihrer Struktur sowie ihrer Funktion jenen Schichten 20, wie sie vorstehend anhand der Fig. 4 erläutert wurden, wobei dort die Schichten 20 auf den Bauteilen 1 anstatt auf der Verbundlage 4' vor-angebracht wurden. Nach Auflaminieren der Verbundlage 4' mit den elektrisch leitenden Teilschichten 20' auf die Bauteile 1, s. Fig. 5c, wird die erhaltene Struktur wieder um 180° gewendet, s. Fig. 5d, und der temporäre Träger 2 in Form der Klebefolie 2 wird entfernt, s. Pfeil x in Fig. 5d. Die anschließenden Schritte gemäß den Fig. 5e, 5f und 5g entsprechen den Schritten 4e, 4f und 4g wie vorstehend erläutert, sodass sich eine neuerliche Beschreibung erübrigen kann.

Das elektrisch leitende Material der Schichten bzw. Teilschichten 20 oder 20' kann beispielsweise anstatt aus einem Bandmaterial auch aus einer Paste bestehen, die ein Metallpulver, wie Silber, und ein Bindemittel enthält. Diese Paste kann thermisch gesintert werden. Sie kann auf der Leiterschicht 6 (oder auf den Bauteilen 1) im Vorhinein durch Aufdrucken, wie etwa Siebdruck, Schablonendruck und ähnliche Auftragstechniken aufgebracht werden. Die Paste wird bei einer erhöhten Temperatur getrocknet, um Bindemittel und Lösungsmittel zu entfernen. Nach dem Trocknen dieses Materials wird eine poröse Struktur erhalten. Ein Verbinden in Vakuum verhindert wiederum das Einschließen von Luftblasen an den Verbindungsflächen zwischen den Bauteilen 1 und den elektrisch leitenden Schichten 20 bzw. 20'. Während des Laminierprozesses wird die poröse Struktur unter Anwendung von Druck und Temperatur verdichtet, sodass sich jeweils feste Metallschichten bei diesem Niedertemperatur-Sinterprozess bilden.

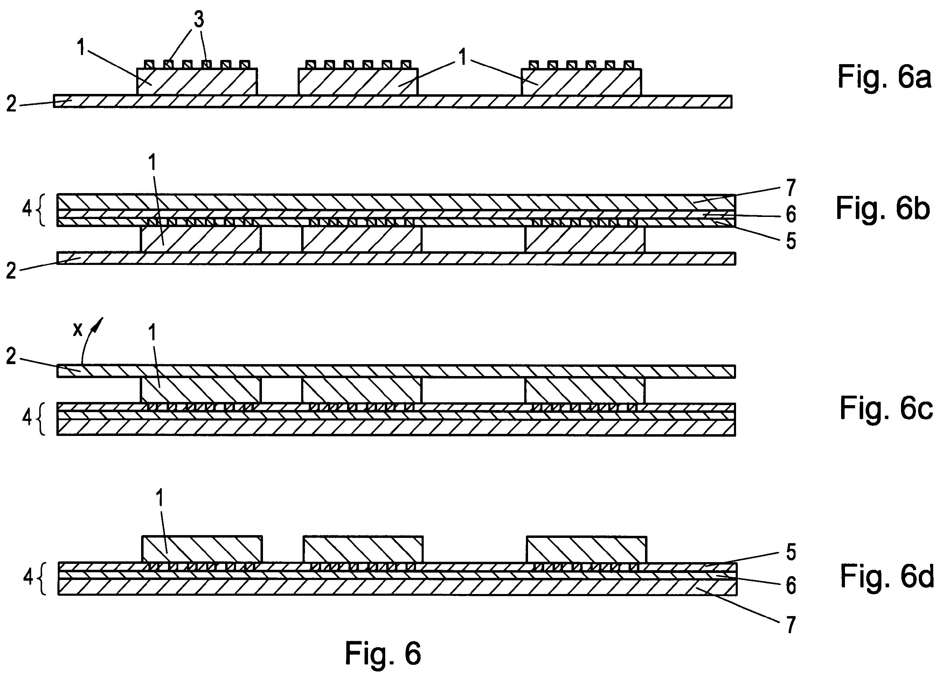

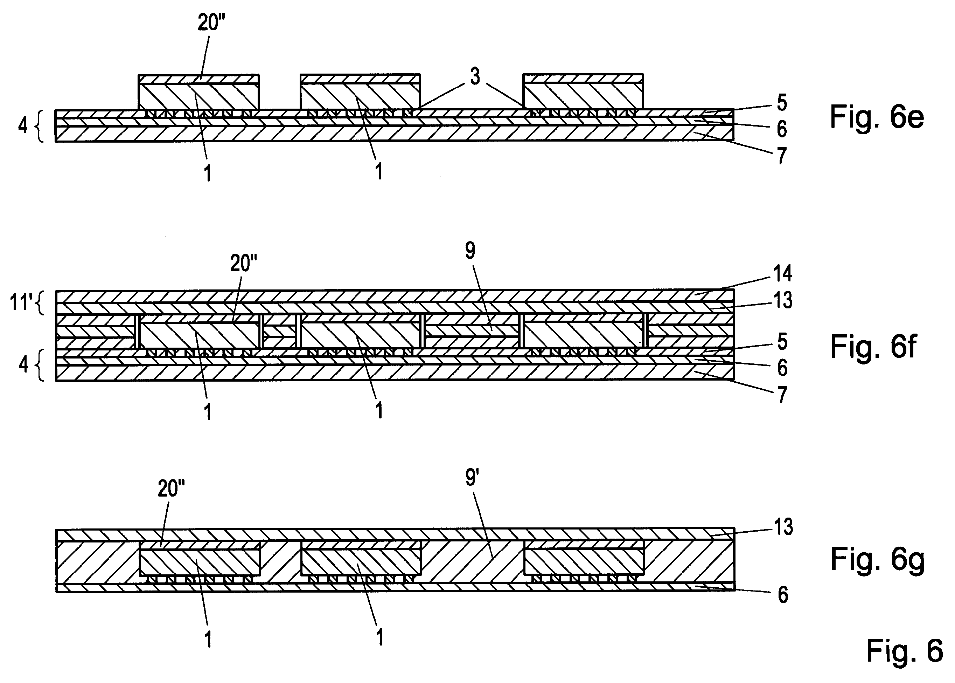

Bei der Verfahrensvariante gemäß Fig. 6 entsprechen die in den Fig. 6a bis 6d dargestellten Verfahrensschritte praktisch den Verfahrensschritten gemäß Fig. 1a bis 1d, wobei allerdings in den Teilfiguren der Fig. 6 der Pressstempel 8 (s. Fig. 1c) weggelassen wurde. Insofern kann sich hier eine neuerliche Erläuterung erübrigen.

Nach dem Schritt gemäß Fig. 6d wird, gemäß Fig. 6e, auf den Bauteilen 1 eine Schicht 20" aus einer elektrisch leitenden Metallpaste aufgebracht, und zwar auf der der Anschlussseite gegenüberliegenden Seite der Bauteile 1. Die elektrisch leitende Paste für die Schichten 20" wird wie zuvor in Zusammenhang mit Fig. 5 beschrieben getrocknet.

Es erfolgt dann ein Auflaminieren einer zusätzlichen zweischichtigen Verbundlage 11' mit einem Leiter 13 und einem Träger 14, s. Fig. 6f, d.h. ohne Isolierschicht 12, nachdem zuvor die Bauteile 1 samt Schicht 20" in einer Prepreg-Isolierung 9 wie beschrieben eingebettet wurden. Schließlich wird, nach Ablösen der Träger 7 und 14, der Verbund gemäß Fig. 6g, mit dem "Leiterplattenkörper 9'", erhalten.

Der Vorteil dieser Vorgangsweise ist ein verringerter Aufwand bei der Registrierung von Prozessschritten. Beim Verfahren gemäß Fig. 5 ist es erforderlich, den temporären Träger 2 mit den daran befestigten Bauteilen 1 zu den leitenden Pasten 20' auf der Verbundlage 4' auszurichten; demgegenüber liegt im Beispiel von Fig. 6 die metallisch leitende Paste auf den Bauteilen 1 vor, und eine Registrierung zur Leiterlage 6 erübrigt sich.

Die Pasten bzw. Schichten 20' bzw. 20" schrumpfen beim Erhitzen und Auflaminieren der Verbundlage 11' mitunter um 50% in der Dicke.

Für eine Positionierung bzw. Registrierung der einzubettenden Bauteile 1 können allgemein Registrierungselemente bzw. - markierungen am temporären Träger 2 vorgesehen werden. Von besonderem Vorteil ist es weiters, wenn für nachfolgende Prozessschritte Registrierelemente 17 angebrachten werden, wie sie in Fig. 1a bis 1e schematisch gezeigt sind. Diese Registrierelemente 17 verbleiben auch nach Entfernen der Klebefolie 2 in der Einheit.

Außer diesen Registrierungselementen 17 können auch bereits auf der Kunststofffolie 2 vorhandene Bauteile 1 als Registrierelemente eingesetzt werden.

Für die temporäre Festlegung der Bauteile 1 ist die Träger-Kunststofffolie 2 wie erwähnt bevorzugt als Klebeband bzw. - folie, insbesondere mit druckempfindlichem Kleber, ausgebildet, was auf einfache Weise eine zuverlässige Positionierung und provisorische Festlegung der Bauteile 1 sowie ein nachfolgendes einfaches Entfernen des temporären Trägers 2 nach dem z.B. in Fig. 1c dargestellten Verfahrensschritt ermöglicht. Für den temporären Träger 2 ist andererseits im Hinblick auf eine zuverlässige Positionierung der Bauteile 1 ein möglichst dimensionsstabiles Trägermaterial von Vorteil.

Zum Ausgleich von unterschiedlichen Höhen der aufzunehmenden Bauteile 1 und gegebenenfalls von Herstellungstoleranzen bei den Abmessungen der aufzunehmenden Bauteile 1 kann es auch zweckmäßig sein, den temporären Träger 2 mit einem ein Eindrücken der dickeren Bauteile 1 ermöglichenden komprimierbaren Material auszurüsten. Mit einem derartigen Ausgleich zwischen unterschiedlich hohen Bauelementen 1 wird in den nachfolgenden Herstellungsschritten, z.B. gemäß Fig. 1b und 1c, ein exaktes Verbinden der Bauteile 1 mit der gemeinsamen Verbundlage 4 ermöglicht.

Eine derartige Ausbildung eines temporären Trägers 2 wie vorstehend angedeutet kann der Darstellung in Fig. 7 entnommen werden. Der hier gezeigte temporäre Träger 2 ist ein mehrschichtiger Aufbau, mit einer Kunststofffolie in Form einer Klebefolie 2', die eine Klebeschicht 21 sowie eine diese Klebeschicht 21 tragende Trägerschicht 22, z.B. aus einem PET-Material, enthält. Als Kleber kann beispielsweise ein Acryl- oder Silikon-Material eingesetzt werden. Unterhalb dieser Klebefolie 2' ist gemäß Fig. 7 eine komprimierbare Schicht 23, etwa aus einem Teflon-Material, angebracht, die ein gewisses Eindrücken von etwa aufgrund ihres Aufbaus oder aufgrund von Toleranzunterschieden eines eine etwas größere Dicke aufweisenden Bauteils 1' erlaubt. Auf diese Weise ist es im späteren Schritt des Aufbringens der Verbundlage 4 bzw. 4', wie in Fig. 7 mit gestrichelten Linien angedeutet, leichter möglich, diese Verbundlage 4 bzw. 4' auf einem im Wesentlichen einheitlichen Niveau über dem Bauteil 1, 1' anzubringen.

Im Hinblick auf die vorstehend bereits angesprochene gute Dimensionsstabilität ist es sodann weiters möglich, bei einem derartigen temporären Verbund-Träger 2 wie in Fig. 7 gezeigt eine dimensionsstabile Schicht oder Lage 25, beispielsweise ein Metallblech, unter Zwischenlage einer Verbindungsschicht 24 an der Unterseite oder Außenseite der komprimierbaren Schicht 23 anzubringen. Die Verbindungsschicht 24 ist bevorzugt aus einem an sich bekannten thermisch oder aber durch UV-Strahlung lösbaren Kleber gebildet, wobei es dann möglich ist, die Dimensionsstabilisierungs-Schicht 25 etwa durch Erhitzen zusammen mit der Klebe- oder Verbindungsschicht 24 von dem Rest des temporären Trägers 2 abzulösen, wonach der restliche temporäre Träger 2, d.h. die Klebeschicht 2' und die komprimierbare Materialschicht 23, von den Bauteilen 1 (1') abgelöst werden kann, nämlich nachdem zuvor auf der gegenüberliegenden Seite der Bauteile 1, 1' die Verbundlage 4 (oder 4') wie beschrieben angebracht wurde. Bei Verwendung von UV-lösbaren Klebern kommt für den Träger 25 ein UV-durchlässiges Material zum Einsatz, um die Ablösung nach dem Laminiervorgang zu ermöglichen.

Im Hinblick auf eine entsprechende mechanische Festigkeit während weiterer Be- bzw. Verarbeitungsschritte kann vorzugsweise auch der Träger 7 der Verbundlage 4 aus einem entsprechend dimensionsstabilen Material, beispielsweise aus einem Metall, wie etwa Kupfer, Aluminium etc., oder aus dimensionsstabilem Polymer bestehen. Weiters ist es denkbar, auch im Bereich der Isoliermaterialschicht 5 der Verbundlage 4 (und in entsprechender Weise bei der Verbundlage 11) eine dimensionsstabile Schicht einzubauen. Dies ist in Fig. 8 in einem schematischen Schnitt gezeigt, wobei oberhalb einer Isoliermaterialschicht 5C, die beispielsweise auch zur Einbettung der Bauteile 1 auf dem temporären Träger 2 herangezogen werden kann und eine dementsprechende Dicke aufweist, eine Schicht 5B aus einem nicht-deformierbaren dielektrischen Material vorgesehen ist. Dieses nicht-deformierbare dielektrische Material 5B ist beispielsweise ein Material mit einem Schmelzpunkt, der höher als 220°C ist, insbesondere höher als 250°C ist. Dadurch wird diese dimensionsstabile Schicht 5B beim Aushärten der eigentlichen Isolierschicht 5C nicht beeinträchtigt.

Zur Erzielung einer geringen Dicke der herzustellenden Leiterplatte wird für die Leiterschicht 6 bzw. die zusätzliche Leiterschicht 13 eine vergleichsweise geringe Dicke gewählt, welche beispielsweise weniger als 20 µm, insbesondere zwischen 10 nm und 10 µm gewählt wird. Die Aufbringung kann z.B. mittels Sputtern erfolgen.

Für die Aufrechterhaltung einer entsprechenden Kontaktierung der Bauteile 1 bzw. einer Verbindung zwischen den Bauteilen 1, insbesondere der die Kontakte 3 aufweisenden Oberflächen, und der Isolierschicht 5 bzw. 12 der Verbundlage 4 bzw. 11 kann diese Isolierschicht 5 bzw. 12 auch aus einem entsprechend temperaturbeständigen Material, beispielsweise einem gehärteten Duroplast, wie Epoxid, gebildet sein. Bei Verwendung derartiger Materialien für die Schicht 5 bzw. 12 lässt sich auch ein gewünschter und entsprechend geringer Abstand zwischen den Kontakten 3 und der Leiterschicht 6 bzw. 13 zuverlässig aufrecht erhalten, so dass wiederum die Höhe der Leiterplatte entsprechend minimiert werden kann.

Es wird ergänzend angemerkt, dass die Abmessungsverhältnisse bzw. relative Abmessungen der einzelnen, in der Zeichnung dargestellten Elemente nicht maßstabgetreu sind.

Mit dem vorliegenden Verfahren wird auch eine mehrlagige Leiterplatte ermöglicht. Durch mehrfache Wiederholung der in der Zeichnung dargestellten und beschriebenen Verfahrensschritte kann eine Multi-Layer-Leiterplatte erhalten werden, wobei in unterschiedlichen Niveaus bzw. Ebenen in einfacher und zuverlässiger Weise elektronische Bauteile 1 integriert werden können.

## Patentansprüche

1. Verfahren zum Herstellen eines Leiterplattenelements mit wenigstens einem elektronischen Bauteil (1), der eine durch elektrische Kontakte oder eine leitende Schicht definierte Anschlussseite aufweist, wobei der Bauteil (1) zur Positionierung mit einem temporären Träger (2) verbunden und in einem Isoliermaterial (9) eingebettet wird, wobei der Bauteil (1) direkt auf einer Kunststofffolie (2) als temporärer Träger (2) in einer vorgegebenen Position angebracht wird, **dadurch gekennzeichnet, dass** nach dem Anbringen des Bauteils (1) auf der Kunststofffolie (2) auf der der Kunststofffolie (2) gegenüberliegenden Seite des Bauteils (1) eine Verbundlage (4, 4') mit zumindest einem Träger (7) und einem elektrischen Leiter (6), vorzugsweise auch mit einem Isoliermaterial (5, 5A), mit dem Träger (7) vom Bauteil (1) abgewandt, angebracht wird, dass danach die Kunststofffolie (2) abgelöst wird, und dass dann der Bauteil (1) in Isoliermaterial (5A; 9) eingebettet wird.

2. Verfahren nach Anspruch 1, **dadurch gekennzeichnet, dass** nach der Einbettung des Bauteils (1) im Isoliermaterial (5A; 9) eine weitere Verbundlage (11), die zumindest einen elektrischen Leiter (13) und einen Träger (14), vorzugsweise auch ein Isoliermaterial (12), aufweist, auf der der ersten Verbundlage (4, 4') gegenüberliegenden Seite auf dem Bauteil (1) und auf dessen Einbettung aufgebracht wird.

3. Verfahren nach Anspruch 1 oder 2, **dadurch gekennzeichnet, dass** eine Klebefolie (2) als temporärer Träger (2) eingesetzt wird.

4. Verfahren nach einem der Ansprüche 1 bis 3, **dadurch gekennzeichnet, dass** der Bauteil (1) in einem als Isoliermaterial (9) zur Einbettung eingesetzten vorkonditionierten Prepreg-Material, das eine Ausnehmung (10) für den Bauteil (1) aufweist, oder im Isoliermaterial (5A) der Verbundlage (4), das eine Schichtdicke zumindest gleich der Dicke des Bauteils (1) hat, eingebettet wird.

5. Verfahren nach einem der Ansprüche 1 bis 4, **dadurch gekennzeichnet, dass** ein Bauteil (1) mit einer auf einer Seite von ihm angebrachten dielektrischen Schicht (5') eingesetzt wird, wobei dieser Bauteil (1) mit der, der dielektrischen Schicht (5') gegenüberliegenden Seite auf der Kunststofffolie (2) angebracht wird.

6. Verfahren nach einem der Ansprüche 1 bis 4, **dadurch gekennzeichnet, dass** ein Bauteil (1) mit einer auf einer Seite von ihm angebrachten elektrisch leitenden Schicht (20) eingesetzt wird, wobei dieser Bauteil (1) mit der, der elektrisch leitenden Schicht (20) gegenüberliegenden Seite auf der Kunststofffolie (2) angebracht wird.

7. Verfahren nach einem der Ansprüche 1 bis 4, **dadurch gekennzeichnet, dass** an der Verbundlage (4'), bestehend aus Träger (7) und elektrischem Leiter (6), ein z.B. pastenförmiges, elektrisch leitendes Material (20'), z.B. durch Drucken, auf dem elektrischen Leiter (6) der Verbundlage (4') an der Stelle des Bauteils (1) angebracht wird, bevor die Verbundlage (4') mit dem Bauteil (1) verbunden und danach die Kunststofffolie (2) abgelöst wird.

8. Verfahren nach einem der Ansprüche 1 bis 4, **dadurch gekennzeichnet, dass** an der der Anschlussseite des Bauteils (1) gegenüberliegenden Seite ein z.B. pastenförmiges, elektrisch leitendes Material (20") nach dem Ablösen der Kunststofffolie (2), z.B. durch Drucken, aufgebracht wird.

9. Verfahren nach einem der Ansprüche 1 bis 8, **dadurch gekennzeichnet, dass** die Verbundlage (4) im Vakuum angebracht wird.

10. Verfahren nach einem der Ansprüche 1 bis 9, **dadurch gekennzeichnet, dass** auf der Kunststofffolie (2) zugleich mit dem Bauteil (1) zumindest ein Registrierelement (17) für die Verwendung bei nachfolgenden Verfahrensschritten aufgebracht wird.

11. Verfahren nach einem der Ansprüche 1 bis 10, **dadurch gekennzeichnet, dass** mit der Kunststofffolie (2) ein komprimierbares Material (23) verbunden wird.

12. Verfahren nach einem der Ansprüche 1 bis 11, **dadurch gekennzeichnet, dass** mit der Kunststofffolie (2) eine dimensionsstabile Schicht, vorzugsweise ein Metallblech (25), verbunden wird, welche im Fall eines komprimierbaren Materials (23) an dessen von dem Bauteil (1, 1') abgewandten Seite lösbar angebracht wird.

13. Verfahren nach einem der Ansprüche 1 bis 12, **dadurch gekennzeichnet, dass** der Träger (7) der Verbundlage (4, 4') und/oder der weiteren Verbundlage (11) aus einem dimensionsstabilen Material, wie einem Metall, z.B. aus Kupfer, Aluminium, oder einem dimensionsstabilen Polymer, welches insbesondere eine UV-Durchlässigkeit aufweist, gebildet wird.

14. Verfahren nach einem der Ansprüche 1 bis 13, **dadurch gekennzeichnet, dass** das Isoliermaterial (5, 12) der Verbundlage (4) und/oder der weiteren Verbundlage (11) aus einem Material, z.B. einem Duroplast, gebildet wird, das seine Viskosität während des Verbindens mit dem Bauteil (1) ändert, oder dass das Isoliermaterial (5, 12) der Verbundlage (4) und/oder der weiteren Verbundlage (11) aus einem nicht-deformierbaren dielektrischen Material (5B) gebildet wird, auf dem eine weitere Schicht (5C) aus nichtleitendem Material angebracht wird, das seine Viskosität während des Verbindens mit dem Bauteil (1) ändert.

15. Verfahren nach Anspruch 14, **dadurch gekennzeichnet, dass** als nicht-deformierbares dielektrisches Material (5B) ein Material mit einem Schmelzpunkt, der höher als 220 °C ist, insbesondere höher als 250 °C ist, gewählt wird.

16. Verfahren nach Anspruch 14 oder 15, **dadurch gekennzeichnet, dass** das Isoliermaterial (5, 12) ein als nicht-deformierbares Material (5B) gehärtetes Duroplast, beispielsweise Epoxid, aufweist.

17. Verfahren nach einem der Ansprüche 1 bis 16, **dadurch gekennzeichnet, dass** nach dem Anbringen, insbesondere Auflaminieren, der Verbundlage (4) und/oder der weiteren Verbundlage (11) deren elektrischer Leiter (6, 13) strukturiert wird und/oder Kontaktverbindungen zu Kontakten (3) des Bauteils (1) hergestellt werden.

## Claims

1. A method for producing a printed circuit board element comprising at least one electronic component (1) which has a connection side defined by electrical contacts or a conductive layer, wherein the component (1) for positioning is connected to a temporary carrier (2) and is embedded in an insulating material (9), wherein the component (1) is affixed directly on a plastic film (2) as a temporary carrier (2) in a predetermined position, **characterised in that**, after affixing the component (1) on the plastic film (2), on the side of the component (1) opposite the plastic film (2), a composite layer (4, 4') with at least one carrier (7) and an electrical conductor (6), preferably also with an insulating material (5, 5A), with the carrier (7) facing away from the component (1), is affixed, **in that** the plastic film (2) is detached, and **in that** the component (1) is then embedded in insulating material (5A; 9).

2. The method according to Claim 1, **characterised in that** after the embedding of the component (1) in insulating material (5A; 9), a further composite carrier (11), which has at least one electrical conductor (13) and a support (14), preferably also an insulating material (12), is applied on the side opposite the first composite layer (4, 4') on the component (1) and on the embedment thereof.

3. The method according to Claim 1 or 2, **characterised in that** an adhesive film (2) is used as temporary carrier (2).

4. The method according to one of Claims 1 to 3, **characterised in that** the component (1) is embedded in a preconditioned prepreg material used as insulating material (9) for embedment, which material has a recess (10) for the component (1), or in the insulating material (5A) of the composite layer (4), which has a layer thickness at least equal to the thickness of the component (1).

5. The method according to one of Claims 1 to 4, **characterised in that** a component (1) with a dielectric layer (5') applied on one side thereof is used, wherein this component (1) is applied on the plastic film (2) using the side opposite the dielectric layer (5').

6. The method according to one of Claims 1 to 4, **characterised in that** a component (1) with an electrically conductive layer (20) applied on one side thereof is used, wherein this component (1) is affixed on the plastic film (2) using the side opposite the electrically conductive layer (20).

7. The method according to one of Claims 1 to 4, **characterised in that** at the composite layer (4') consisting of carrier (7) and electrical conductor (6), an e.g. pasty, electrically conductive material (20') is affixed, e.g. by printing, on the electrical conductor (6) of the composite layer (4') at the site of the component (1) before the composite layer (4') is connected to the component (1) and the plastic film (2) is subsequently detached.

8. The method according to one of Claims 1 to 4, **characterised in that** an e.g. pasty electrically conductive material (20") is affixed, e.g. by printing, on the side opposite the connection side of the component (1), after detaching the plastic film (2).

9. The method according to one of Claims 1 to 8, **characterised in that** the composite layer (4) is affixed in a vacuum.

10. The method according to one of Claims 1 to 9, **characterised in that** at least one registration element (17) for use during subsequent method steps is applied on the plastic film (2) at the same time as the component (1).

11. The method according to one of Claims 1 to 10, **characterised in that** a compressible material (23) is connected to the plastic film (2).

12. The method according to one of Claims 1 to 11, **characterised in that** a dimensionally stable layer, preferably a metal sheet (25), is connected to the plastic film (2), which dimensionally stable layer is releasably affixed in the case of a compressible material (23) to the side thereof facing away from the component (1, 1').

13. The method according to one of Claims 1 to 12, **characterised in that** the carrier (7) of the composite layer (4, 4') and/or the further composite layer (11) is formed from a dimensionally stable material, such as a metal, e.g. from copper, aluminium or a dimensionally stable polymer, which has a UV transmittance in particular.

14. The method according to one of Claims 1 to 13, **characterised in that** the insulating material (5, 12) of the composite layer (4) and/or the further composite layer (11) is formed of a material, e.g. a duroplastic, which changes its viscosity during connection to the component (1), or **in that** the insulating material (5, 12) of the composite layer (4) and/or the further composite layer (11) is formed from a non-deformable dielectric material (5B), on which a further layer (5C) made from non-conductive material, which changes its viscosity during connection to the component (1), is affixed.

15. The method according to Claim 14, **characterised in that** a material with a melting point which is higher than 220°C, particularly higher than 250°C, is chosen as non-deformable dielectric material (5B).

16. The method according to Claim 14 or 15, **characterised in that** the insulating material (5, 12) comprises a duroplastic hardened as a non-deformable material (5B), for example epoxy.

17. The method according to one of Claims 1 to 16, **characterised in that** after the affixing, particularly lamination, of the composite layer (4) and/or the further composite layer (11), the electrical conductor (6, 13) thereof is structured and/or contact connections to contacts (3) of the component (1) are produced.

## Revendications

1. Procédé de fabrication d'un élément de plaque de circuit imprimé comprenant au moins un composant électronique (1), qui présente un côté de raccordement défini par des contacts électriques ou une couche conductrice, le composant (1) étant, pour son positionnement, relié à un support temporaire (2) et encastré dans un matériau isolant (9), le composant (1) étant appliqué directement, dans une position prédéterminée, sur une feuille de matière plastique (2) en guise de support temporaire (2),
**caractérisé en ce qu'**après l'application du composant (1) sur la feuille de matière plastique (2), on applique sur le côté du composant (1), qui est opposé à celui où se trouve la feuille de matière plastique (2), une couche composite (4, 4') comprenant au moins un substrat de support (7) et un conducteur électrique (6), de préférence également un matériau isolant (5, 5A), avec le substrat de support (7) éloigné du composant (1), **en ce qu'**on détache ensuite la feuille de matière plastique (2), et **en ce que** le composant (1) est ensuite encastré dans du matériau isolant (5A; 9).

2. Procédé selon la revendication 1, **caractérisé en ce qu'**après l'encastrement du composant (1) dans le matériau isolant (5A; 9), on applique une autre couche composite (11), qui comprend au moins un conducteur électrique (13) et un substrat de support (14), de préférence également un matériau isolant (12), sur le côté du composant (1) opposé à celui où se trouve la première couche composite (4, 4'), et sur son matériau d'encastrement.

3. Procédé selon la revendication 1 ou la revendication 2, **caractérisé en ce que** l'on utilise une feuille adhésive (2) en guise de support temporaire (2).

4. Procédé selon l'une des revendications 1 à 3, **caractérisé en ce que** le composant (1) est encastré dans un matériau pré-imprégné dit prépreg, pré-conditionné, utilisé en tant que matériau isolant (9) pour l'encastrement et comportant un évidement (10) pour le composant (1), ou est encastré dans le matériau isolant (5A) de la couche composite (4), qui présente une épaisseur de couche au moins égale à l'épaisseur du composant (1).

5. Procédé selon l'une des revendications 1 à 4, **caractérisé en ce que** l'on utilise un composant (1) sur un côté duquel a été appliquée une couche diélectrique (5'), ce composant (1) étant appliqué, avec son côté opposé à celui où se trouve la couche diélectrique (5'), sur la feuille de matière plastique (2).

6. Procédé selon l'une des revendications 1 à 4, **caractérisé en ce que** l'on utilise un composant (1) sur un côté duquel a été appliquée une couche électriquement conductrice (20), ce composant (1) étant appliqué avec son côté opposé à celui où se trouve la couche électriquement conductrice (20), sur la feuille de matière plastique (2).

7. Procédé selon l'une des revendications 1 à 4, **caractérisé en ce que** sur la couche composite (4'), constituée du substrat de support (7) et du conducteur électrique (6), est appliqué, par exemple par impression, un matériau électriquement conducteur (20'), par exemple sous forme de pâte, sur le conducteur électrique (6) de la couche composite (4') à l'endroit du composant (1), avant de relier la couche composite (4') au composant (1), et ensuite détacher la feuille de matière plastique (2).

8. Procédé selon l'une des revendications 1 à 4, **caractérisé en ce qu'**après le détachement de la feuille de matière plastique (2), on applique, par exemple par impression, sur le côté du composant (1), qui est opposé au côté de raccordement, un matériau électriquement conducteur (20"), par exemple sous forme de pâte.

9. Procédé selon l'une des revendications 1 à 8, **caractérisé en ce que** la couche composite (4) est appliquée sous vide.

10. Procédé selon l'une des revendications 1 à 9, **caractérisé en ce que** l'on applique sur la feuille de matière plastique (2), en même temps que le composant (1), au moins un élément d'enregistrement (17) destiné à être utilisé lors d'étapes ultérieures du procédé.

11. Procédé selon l'une des revendications 1 à 10, **caractérisé en ce que** l'on relie à la feuille de matière plastique (2), un matériau compressible (23).

12. Procédé selon l'une des revendications 1 à 11, **caractérisé en ce que** l'on relie à la feuille de matière plastique (2), une couche de dimensions stables, de préférence une tôle métallique (25), qui, dans le cas d'un matériau compressible (23), est appliquée de manière amovible sur son côté éloigné du composant (1, 1').

13. Procédé selon l'une des revendications 1 à 12, **caractérisé en ce que** le substrat de support (7) de la couche composite (4, 4') et/ou de ladite autre couche composite (11), est formé par un matériau de dimensions stables, comme un métal, par exemple du cuivre, de l'aluminium, ou par un polymère de dimensions stables, qui présente notamment une perméabilité aux UV.

14. Procédé selon l'une des revendications 1 à 13, **caractérisé en ce que** le matériau isolant (5, 12) de la couche composite (4) et/ou de ladite autre couche composite (11), est formé par un matériau, par exemple un thermodurcissable, dont la viscosité varie pendant la liaison avec le composant (1), ou **en ce que** le matériau isolant (5, 12) de la couche composite (4) et/ou de ladite autre couche composite (11), est formé par un matériau diélectrique (5B) non déformable, sur lequel est appliqué une autre couche (5C) en un matériau non conducteur, dont la viscosité varie pendant la liaison avec le composant (1).

15. Procédé selon la revendication 14, **caractérisé en ce que** l'on choisit en guise de matériau diélectrique (5B) non déformable, un matériau avec un point de fusion, qui est supérieur à 220 °C, notamment supérieur à 250 °C.

16. Procédé selon la revendication 14 ou la revendication 15, **caractérisé en ce que** le matériau isolant (5, 12) comporte un thermoplastique durci en tant que matériau (5B) non déformable, par exemple un époxyde.

17. Procédé selon l'une des revendications 1 à 16, **caractérisé en ce qu'**après l'application, notamment l'application par laminage de stratification, de la couche composite (4) et/ou de ladite autre couche composite (11), on procède à la structuration de leur conducteur électrique (6, 3) et/ou on établit des liaisons de connexion avec des contacts (3) du composant (1).
